**Europäisches Patentamt**

**European Patent Office**

**Office européen des brevets**

(19)

(11) Veröffentlichungsnummer: **0 167 867**

**A2**

(12) # EUROPÄISCHE PATENTANMELDUNG

(21) Anmeldenummer: **85107263.7**

(22) Anmeldetag: **12.06.85**

(51) Int. Cl.⁴: **H 05 K 3/46**

(30) Priorität: **22.06.84 DE 3423181**

(43) Veröffentlichungstag der Anmeldung:
**15.01.86 Patentblatt 86/3**

(84) Benannte Vertragsstaaten:
**AT BE CH DE FR GB IT LI LU NL SE**

(71) Anmelder: **President Engineering Corp.**
**Florastrasse 11**
**CH-8008 Zürich(CH)**

(72) Erfinder: **Buger, Rainer**
**Auf dem Sandberg 9**
**D-5216 Niederkassel-Ranzel(DE)**

(74) Vertreter: **Eitle, Werner, Dipl.-Ing. et al,**
**Hoffmann, Eitle & Partner Patentanwälte Arabellastrasse**
**4**
**D-8000 München 81(DE)**

(54) **Fixierter Lagenaufbau und Verfahren zur Herstellung von Mehrlagenleiterplatten unter Verwendung dieses Lagenaufbaus.**

(57) Bei diesem Verfahren zur Herstellung von Mehrlagenlei-terplatten wird bereits vor dem Aushärtevorgang der Lage-naufbau aus Laminaten und Prepregs unter Verwendung von mechanischen Verbindungselementen so zusammengefügt, daß die Laminate, bevorzugt unter Stoffschluß, relativ zeuinander fixiert sind.

Der Langenaufbau selbst inst also dadurch charakteri-siert, daß er unter Verwendung von mechanischen Verbindungselementen (5) so zusammengefügt ist, daß die Lami-nate (1, 2) durch die Verbindungselemente (5) relativ zuein-ander fixiert sind.

## FIG. 2

EP 0 167 867 A2

BEZEICHNUNG GEÄNDERT        v/er
  Siehe Titelseite

Verfahren zur Herstellung von Mehrlagenleiterplatten, nach diesem Verfahren hergestellter, fixierter Lagenaufbau und Verwendung dieses Lagenaufbaus bei diesem Herstellungsverfahren

Die Erfindung betrifft ein Verfahren zur Herstellung von Mehrlagenleiterplatten mit in wenigstens drei Ebenen liegenden Leiterbildern, bei dem wenigstens zwei Laminate unter Zwischenschaltung wenigstens eines Prepregs übereinander angeordnet und mittels eines Paßloch-Systems, mit dem die Laminate im Randbereich versehen sind, relativ zueinander ausgerichtet werden, und dieser Lagenaufbau dem Aushärtevorgang unter Druck und Temperatur unterworfen wird.

Ferner bezieht sich die Erfindung auf einen speziellen, nach diesem Verfahren hergestellten Lagenaufbau, der eine Zwischenstufe bei der Herstellung von erfindungsgemäßen Mehrlagenleiterplatten darstellt, sowie auf dessen Verwendung in dem angesprochenen Herstellungsverfahren.

Unter Mehrlagenleiterplatten (Multilayern) wird ein Lagenaufbau von zwei oder mehreren Laminaten, z.B. dünnen Epoxidglasharzgeweben (Dünnlaminaten), mit je einem oder zwei geätzten Leiterbildern verstanden, zwischen denen Prepregs, z.B. Epoxidglasgewebe, in noch nicht ausgehärtetem sogenannten B-Zustand angeordnet sind, und der durch Aushärten unter Druck und
Temperatur in einer Presse zu einer Einheit verbunden
wird.

Derartige Mehrlagenleiterplatten werden in der professionellen Elektronik verwendet.

Bei einem bekannten Verfahren zur Herstellung von
Mehrlagenleiterplatten erfolgt sowohl die lagerichtige Anordnung der Laminate und damit der Leiterbilder
als auch das Verpressen der Laminate mit den Prepregs
unter Druck und Temperatur in einem Arbeitsvorgang.
Dazu weisen die Preßformen Paßstifte auf, auf die die
Laminate mit ihren Paßbohrungen aufgesetzt werden,
worauf die derart in Preßformen lagegesicherten
Schichtaufbauten dem Preßvorgang in der Presse unterzogen werden. Bei diesem sogenannten Pin-Laminations-Verfahren ist nachteilig, daß die Preßformen
sowie alle Hilfselemente, wie Preßbleche, Preßpolster
und Trennfolien, wie die Laminate ebenfalls mit Paßbohrungen für die Paßstifte versehen werden müssen,
was sehr aufwendig ist. Ferner verringern die Preßformen die nutzbare Aufnahmekapazität der Presse und
erhöhen den Wärmebedarf für den Aushärtevorgang. Ein
weiterer Nachteil besteht darin, daß bei der Herstellung von Mehrlagenleiterplatten unterschiedlicher
Formate entsprechend angepaßte Preßformen einschließlich der angeführten Hilfselemente angefertigt und
bereitgehalten werden müssen oder aber bei einer auf
das Preßformat abgestimmten Einheitsform erhöhter
Materialabfall durch

schlechte Nutzung entsteht. Beides bedeutet eine wesentliche Produktverteuerung.

Gegenüber der beschriebenen Produktionsweise ist es Aufgabe der Erfindung, ein Verfahren zur Herstellung von Mehrlagenleiterplatten anzugeben, das eine kostengünstige und flexible Produktion nach modernen Methoden unter voller Beibehaltung der hohen Präzision, insbesondere der Lagegenauigkeit, der Laminate und damit der Leiterbilder ermöglicht.

Diese Aufgabe wird bei einem Verfahren mit den eingangs genannten Verfahrensschritten dadurch gelöst, daß bereits vor dem Aushärtevorgang der Lagenaufbau unter Verwendung von mechanischen Verbindungselementen so zusammengefügt wird, daß die Laminate relativ zueinander fixiert sind.

Die Erfindung beruht also auf dem grundsätzlichen Gedanken, daß der Lagenaufbau aus Laminaten und Prepregs in einer Zwischenstufe des gesamten Herstellungsvorgangs vor dem Aushärtevorgang durch Druck und Temperatur zu einer eine Art Halbzeug darstellenden eine Einheit verbunden wird, in der die Laminate und damit deren Leiterbilder in der gewünschten Präzision dauerhaft und sicher relativ zueinander fixiert sind. Diese Einheiten sind ohne besondere Vorsichtsmaßnahmen handhabbar und können nach Bedarf zwischengelagert werden, bevor sie dem endgültigen Verbindungsvorgang, nämlich dem Aushärten unter Druck und Temperatur, unterworfen werden.

Dies stellt eine Abkehr von der bisher bekannten Herstellungsmethode dar, bei der, wie geschildert, in Preßwerkzeugen mit Paßstiften sowohl die Lageorientierung der Laminate als auch das Verpressen dieser Laminate mit den Prepregs stattfindet.

Ein Verschieben der Laminate und damit der Leiterbilder während des Aushärtevorgangs unter Druck wird bei dem erfindungsgemäßen Verfahren deshalb zuverlässig ausgeschlossen, weil nach den wesentlichen Merkmalen die Verbindungselemente die Laminate sicher relativ zueinander fixieren und die dazwischen liegenden Prepregs ebenfalls mit ausreichender Genauigkeit an ihrem Ort halten.

Darüber hinaus liegen nach einer besonders bevorzugten Ausführungsform die Laminate im Bereich der Verbindungselemente mit Stoffschluß aneinander, so daß ein Fließen der Prepregs beim Preßvorgang ohne Einfluß auf die Lagefixierung der Laminate bleibt.

Zur Erzielung dieses Stoffschlusses werden zumindest die außen liegenden Laminate in ihren Randbereichen außerhalb der Prepregs durch die Verbindungsmittel entsprechend verformt, wozu auch die zwischen den benachbarten Laminaten einzufügenden Prepregs entsprechend ausgebildet sind. Nach einer ersten Ausführungsform können die Prepregs in den Randzonen im Bereich der Verbindungselemente Aussparungen aufweisen, die einen Stoffschluß der benachbarten Laminate aufgrund deren entsprechenden Verformung ermöglichen. Dadurch ist es möglich, die Nutzfläche der Multilayer unter Berücksichtigung der Restfließzeit der Prepregs möglichst groß zu gestalten. Nach einer anderen Ausführungsvariante besitzen die Prepregs kleinere Abmessungen als die durch das Paßlochsystem definierte Fläche. Danach sind also die Prepregs einfach rechteckig zugeschnitten, so daß sie mit den üblichen Werkzeugen kostengünstig hergestellt werden können.

Werden die erfindungsgemäß vorfixierten Einheiten in einer mechanischen, z.B. hydraulischen, Presse, endgültig verpreßt, ist darauf zu achten, daß während dieser Verfahrensschritte kein Druck auf die Verbindungselemente ausgeübt wird, so daß die mechanischen Verbindungselemente auch während des Preßvorgangs die Laminatenlage sicher zueinander fixieren. Nach einer ersten Version kann dies dadurch erreicht werden, daß die Laminate mittels den Verbindungselementen unter Verformung verspannt werden, daß deren Endflächen gegenüber den Außenflächen des fixierten Lagenaufbaus soweit zurückgesetzt sind, daß die Presse keinen Druck auf die Verbindungselemente ausübt, sondern ausschließlich auf den Lagenaufbau im Bereich der Prepregs. Die Verbindungselemente können also ohne weiteres innerhalb des Preßwerkzeugs, insbesondere innerhalb der Preßplatten, liegen.

Nach einer weiteren Version ist es aber auch möglich, die Verbindungselemente so anzuordnen, daß sie außerhalb des Preßwerkzeugs, d.h. der Preßplatten, zu liegen kommen, so daß beim Preßvorgang in der Presse ebenfalls kein Druck auf die Verbindungselemente erfolgt, sondern ausschließlich auf den Lagenaufbau im Bereich der Prepregs.

In beiden Fällen können die erfindungsgemäß vorfixierten Einheiten - übereinander und/oder nebeneinander auf Preßblechen frei verteilt - in einer stationären Presse verpreßt werden. Gegenüber dem Pin-Laminationsverfahren wird also der Vorteil erreicht, daß keine Preßformen benötigt werden und durch deren Wegfall auch die Kapazität der Pressen besser genutzt werden kann. Auf diese Weise sind für die rationelle Fertigung von Mehrlagenleiterplatten auch stationäre Pressen geeignet.

Die erfindungsgemäß vorfixierten Einheiten können des weiteren mit Vorteil in einer Doppelbandpresse verpreßt werden, wodurch eine kontinuierliche Fertigung von Mehrlagenleiterplatten ermöglicht wird.

Schließlich erlauben die erfindungsgemäß vorfixierten Einheiten, den Aushärtevorgang unter Vakuum oder hydraulischem oder pneumatischem Druck durchzuführen. Sie eröffnen also die Anwendung neuer Technologien für den Aushärtevorgang, die sich im Rahmen einer Großserienfertigung schon anbieten oder noch anbieten können.

Nach einer grundsätzlichen Fertigungsmethode der erfindungsgemäß vorfixierten Einheiten werden mit den mechanischen Verbindungselementen sowohl die Lageausrichtung der Laminate als auch deren relative Fixierung zueinander bewirkt. Dazu werden entsprechende Verbindungselemente unter genügend genauer Passung mindestens durch zwei Paßlöcher in den übereinander angeordneten Laminaten hindurchgeführt, wodurch gleichzeitig eine Lageausrichtung der Laminate einerseits und andererseits deren Fixierung untereinander erreicht werden.

Solche Verbindungsmittel können in erster Linie Nieten sein, und zwar Hohlnieten oder Blechnieten, die bevorzugt aus Aluminium oder einer Aluminiumlegierung bestehen. In erster Linie werden sich Nieten anbieten, da diese kostengünstig sind und mit einfachen Vorrichtungen gesetzt werden können Es kann aber auch an Schraubverbindungen aus Stahl oder Kunststoff gedacht werden.

Nach einer anderen Herstellungsweise der erfindungsgemäß vorfixierten Einheiten erfolgt die Lageausrichtung der Laminate mittels einer Paßstiftanordnung in einem Hilfswerkzeug, und es werden die mechanischen Verbindungselemente erst nach Ausrichtung der Laminate an der zu verbindenden Einheit angebracht, um diese für die weiteren Bearbeitungsvorgänge vorzufixieren. Nach dem Anbringen der Verbindungselemente können die fixierten Einheiten von den Paßstiften der Hilfsvorrichtung abgezogen und frei handhabbar einer Zwischenlagerung oder den weiteren Bearbeitungsgängen zugeführt werden.

Als Verbindungselemente für diese Herstellungsmethode der vorfixierten Einheiten bieten sich einerseits Klammerverbindungen an. Hierbei können Metallklammern eingesetzt werden. Dabei werden die mit Leiterbildern versehenen Laminate mit Paßstiften zueinander lagegenau ausgerichtet. Danach werden die Klammern im Randbereich durch die Laminate hindurchgetrieben, wodurch die Fixierung und ggf. der Stoffschluß der Laminate hergestellt werden. Die Paßstifte, welche nur der Montagefixierung dienen, können danach entfernt werden.

Es ist aber auch andererseits möglich, die Verbindung der Laminate durch Verschweißen zu erreichen. Dabei werden die Laminate in ihrem Randbereich bevorzugt über die Metallfolien miteinander verschweißt. Auch hier werden danach die zur Vormontage verwendeten Paßstifte entfernt.

Die erfindungsgemäß hergestellten vorfixierten Einheiten können auch in Kombination mit dem Mass-Laminationsverfahren mit Vorteil eingesetzt werden. Dieses Verfahren ist zur Fertigung von Mehrlagenleiterplatten mit in mindestens drei und höchstens vier Ebenen angeordneten Leiterbildern in einem Preßvorgang ausgelegt. Im Gegensatz zum Pin-Laminationsverfahren wird dabei allerdings ein Laminat mit einem Leiterbild oder zwei Leiterbildern beidseitig mit Prepregs und je einer äußeren Metallfolie ohne Paßstifte zwischen Preßblechen dem Aushärtevorgang unterworfen. Die Zuordnung der innenliegenden Leiterbilder erfolgt durch ein sogenanntes herstellerinternes Paßloch-System oder mittels optisch erfaßbarer Fadenkreuze.

Werden Leiterplatten mit in mehr als vier Ebenen liegenden Leiterbildern verlangt, dann können im Mass-Laminationsverfahren in einem weiteren Arbeitsgang höchstens zwei weitere leitende Ebenen aufgebracht werden. Das erfordert jedoch einen weiteren Aushärtevorgang und verteuert das Erzeugnis dadurch, daß der Ausstoß einer gegebenen Pressenkapazität wegen des zweimaligen Preßvorgangs halbiert wird.

Dieser Nachteil wird dadurch überwunden, daß im Mass-Laminationsverfahren statt eines Laminates mit höchstens zwei Leiterbildern als Innenlage eine erfindungsgemäß vorfixierte Einheit mit mehreren Leiterbildern verwendet und diese Einheit durch die Kombination mit dem Mass-Laminationsverfahren in einem einzigen Aushärtevorgang um zwei weitere leitende Ebenen erweitert wird.

Nach dem Verpressen können die überstehenden beidseitigen Metallfolien in den mit den dazugehörigen Prepregs nicht verklebten Bereichen wie bekannt entfernt werden, wodurch der Zugang zum Paßloch-System der innenliegenden Laminate wieder für die weitere Bearbeitung freiliegt.

So können durch Kombination der beiden Verfahren kostengünstig hochpräzise Leiterplatten mit mehr als vier leitenden Ebenen in einem einzigen Aushärtevorgang hergestellt werden.

Die erfindungsgemäße Zwischenstufe in Form eines fixierten Lagenaufbaus ergibt also mehrere gewichtige und überraschende Vorteile.

Ferner betrifft die Erfindung einen Lagenaufbau, der nach dem geschilderten erfindungsgemäßen Verfahren vorfixiert und danach erst dem Preßvorgang unterworfen wird. Dieses Halbzeug bzw. dieses in einer Zwischenstufe hergestellte Produkt ermöglicht die Erzielung der geschilderten Vorteile. Schließlich bezieht sich die Erfindung auf die Verwendung der fixierten Einheiten zur Herstellung von Multilayer. Insoweit darf auf die Ansprüche verwiesen werden.

Das erfindungsgemäße Verfahren und die durch das erfindungsgemäße Verfahren herstellbare vorfixierte Einheit, die erst anschließend den weiteren Bearbeitungsgängen, insbesondere dem Preßvorgang, unterworfen wird, werden im folgenden anhand eines Beispiels und unter Bezugnahme auf die Zeichnungen weiter erläutert.

Es zeigt:

Fig. 1 eine perspektivische Darstellung eines erfindungsgemäß vorfixierten Lagenaufbaus,

Fig. 2 einen Schnitt durch die Anordnung nach Fig. 1,

Fig. 3 eine auseinandergezogene perspektivische Darstellung eines Lagenaufbaus mit Prepregs mit Aussparungen, und

Fig. 4 eine auseinandergezogene perspektivische Darstellung eines Lagenaufbaus mit Prepregs, die ein Format aufweisen, das kleiner ist als die vom Paßloch-System definierte Fläche.

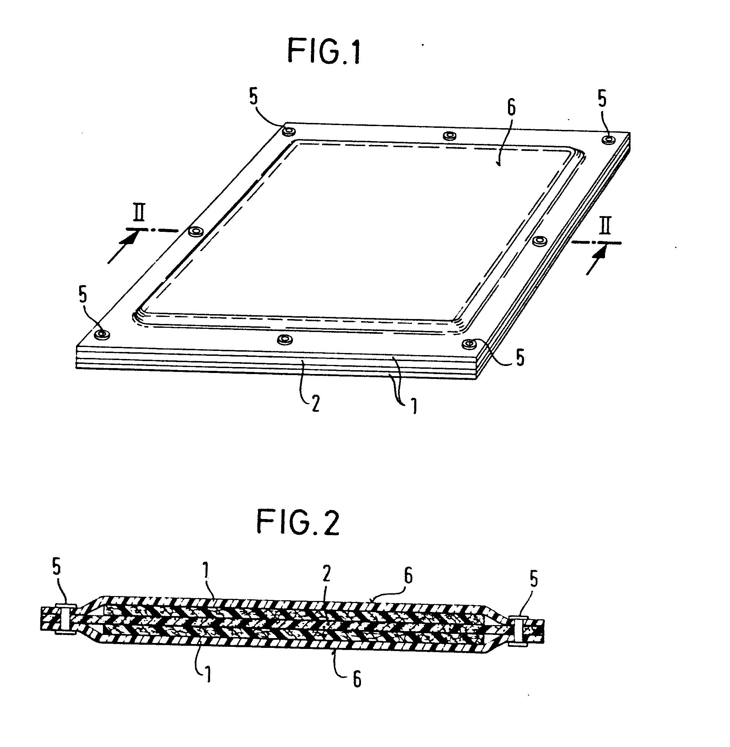

Aus Fig. 1 und Fig. 2 ist der Aufbau eines erfindungsgemäßen, vorfixierten Lagenaufbaus sowie dessen Herstellungweise erkennbar. Über ein vorbestimmtes Paßloch-System 4 werden beseitig mit fertigen Leiterbildern versehene innen liegende Laminate 2 mit außenseitig mit Metallfolie bedeckten, außen liegenden Laminaten 1 unter Zwischenschaltung von Prepregs 3 mittels Nieten 5 fest verbunden. Die Prepregs 3, welche als elektrische Isolierung und Klebewerkstoff notwendig sind, werden um die einzelnen Nieten ausgespart, so daß alle zu fixierenden Innenlagen 2 und Außenlagen 1 im Nietbereich einen Materialschluß aufweisen. Dadurch sind die Lagen 1, 2 und damit die späteren Anschlußpunkte zum Durchmetallisieren der Mehrlagenleiterplatte deckungsgleich zueinander fixiert.

Die äußeren Laminate 1 können in einer anderen Ausführungsform auf der äußeren Seite eine volle Metallfolienauflage und auf der anderen Seite bereits ein geätztes Leiterbild besitzen. Dadurch erhöht sich die Anzahl der Leiterbahnebenen.

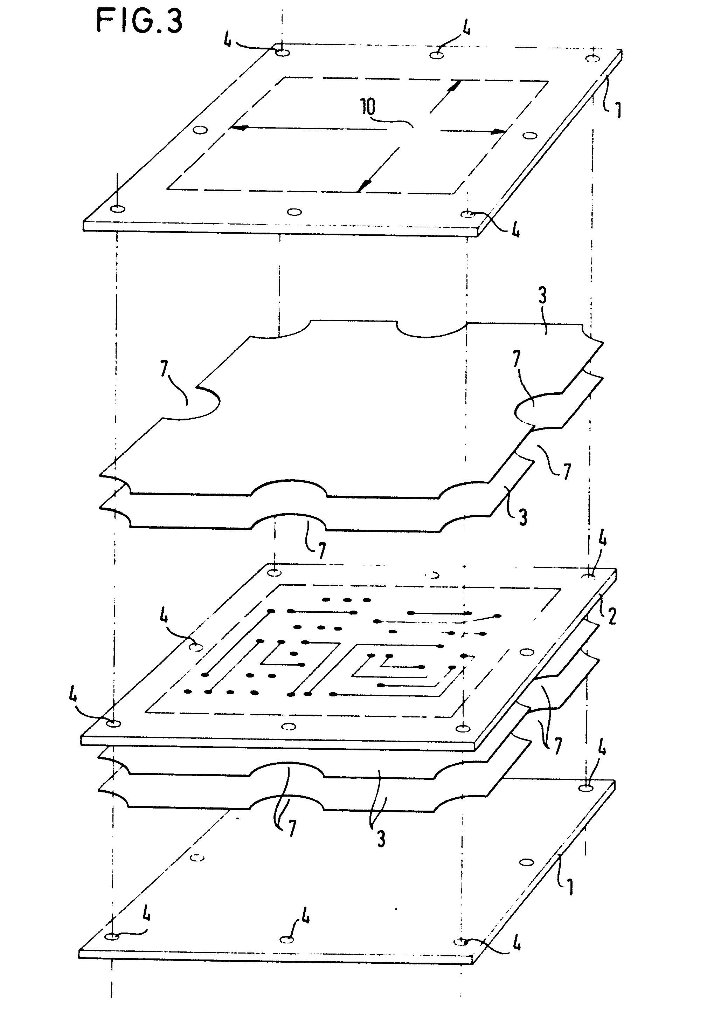

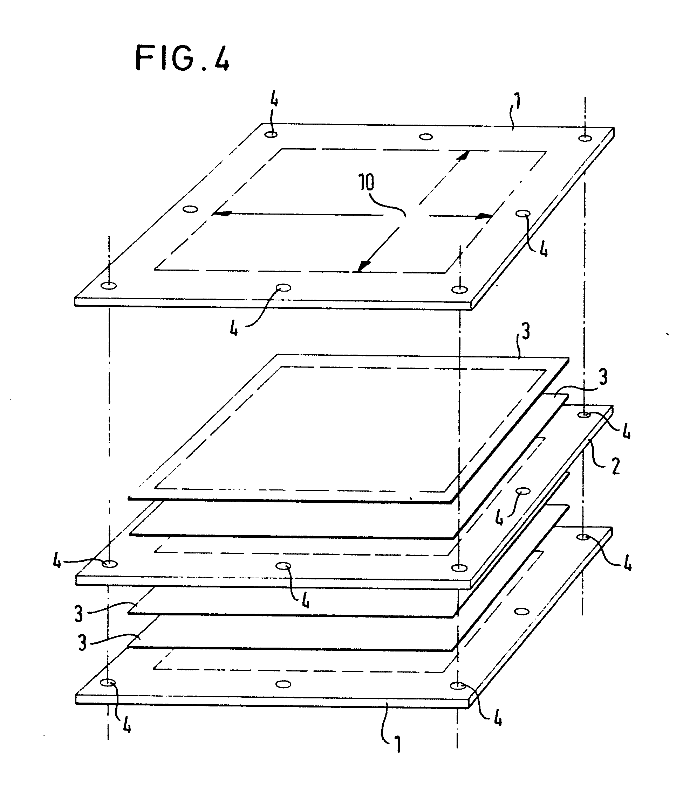

Die Fig. 3 und 4 zeigen zwei mögliche Ausbildungen der für das Verfahren benötigten Prepregs 3. Es wird, wie bereits erläutert worden ist, sichergestellt, daß die Laminate 1, 2 mindestens im Bereich der Nieten 5 unter Stoffschluß aneinander anliegen. Nach Fig. 3 weisen hierzu die Prepregs 3, die natürlich größer sind als das spätere Multilayer-Endformat 10, zumindestens im Bereich derjenigen Paßlöcher 4, die mit Nieten 5 besetzt werden, Aussparungen 7 auf, so daß ein Materialschluß der benachbarten Laminate 1, 2 im Bereich der Nietverbindungen stattfinden kann. Nach Fig. 4 besitzen die Prepregs 3 zwar ein größeres Format als das Multilayer-Endformat 10, aber kleinere Abmessungen als die durch das Paßloch-System 4 definierte Fläche. Während bei dem Ausführungsbeispiel nach Fig. 3 die Multilayer-Nutzfläche möglichst groß ist, wird bei dem Ausführungsbeispiel nach Fig. 4 Prepreg-Werkstoff eingespart.

Falls die erfindungsgemäß vorfixierten Einheiten in übereinander geschichteter Form in einer hydrauli-

schen Presse, natürlich ohne Verwendung der beim Pin-Laminationsverfahren benötigten Preßformen, verpreßt werden sollen, muß sichergestellt werden, daß die Nieten 5 keiner Druckbelastung ausgesetzt sind. Hierzu werden, wie am besten aus Fig. 2 ersichtlich, die außen liegenden Laminate 1 so mit dem innenliegenden Laminat 2 mittels der Nieten 5 miteinander verspannt, daß deren Endflächen gegenüber den Außenflächen 6 des Lagenaufbaus entsprechend weit zurückgesetzt sind. Daraus resultiert, daß während des Preßvorgangs der Preßdruck nur auf der Prepregfläche wirksam ist und die tiefer liegenden Nieten keiner Druckbelastung während des Preßvorgangs ausgesetzt sind. Damit gewährleisten die Nieten 5 und die stoffschlüssige Verbindung der Laminate 1, 2 eine lagegenaue Fixierung auch während des Preßvorgangs, so daß Mehrlagenleiterplatten mit hochpräziser Lagegenauigkeit entstehen.

Um eine exakte, vorher bestimmte Bohrerpositionierung zu den elektrischen Anschlußpunkten zu gewährleisten, müssen entsprechende Aufnahmebohrungen in den verpreßten Multilayer gebohrt werden. Das Einbringen dieser Aufnahmebohrungen kann auf verschiedene und an sich bekannte Arten durchgeführt werden. In jedem Fall muß es positionsgenau zum Leiterbild der Innenlagen 2 passen. Eine besonders gute Positionierung wird dadurch erreicht, daß zur Aufnahme auf dem Bohrautomaten die bereits vorhandenen, nicht mit Nieten 5 gefüllten Paßlöcher der Laminate 1, 2 benutzt werden. Falls mit Nieten 5 besetzte Paßlöcher 4 verwendt werden sollen, kann man die Nieten 5 einem chemischen Ätzprozeß aussetzen, um diese zu entfernen.

**0167867**

Patentansprüche:

1. Verfahren zur Herstellung von Mehrlagenleiterplatten mit in wenigstens drei Ebenen liegenden
Leiterbildern, bei dem

    a) wenigstens zwei Laminate unter Zwischenschaltung wenigstens eines Prepregs übereinander angeordnet und

    b) mittels eines Paßloch-Systems, mit dem die
Laminate im Randbereich versehen sind, relativ zueinander ausgerichtet werden, und

    c) dieser Lagenaufbau dem Aushärtevorgang unter
Druck und Temperatur unterworfen wird,

    dadurch gekennzeichnet, daß

    d) bereits vor dem Aushärtevorgang der Lagenaufbau unter Verwendung von mechanischen Verbindungselementen so zusammengefügt wird, daß
die Laminate relativ zueinander fixiert sind.

2. Verfahren nach Anspruch 1, dadurch gekennzeichnet, daß die Laminate im Bereich der Verbindungselemente unter Stoffschluß stehen.

3. Verfahren nach mindestens einem der Ansprüche 1
und 2, dadurch gekennzeichnet, daß die Prepregs
in den Randzonen im Bereich der Verbindungselemente Aussparungen aufweisen, die einen Stoffschluß der benachbarten Laminate ermöglichen.

4. Verfahren nach mindestens einem der Ansprüche 1
bis 2, dadurch gekennzeichnet, daß die Prepregs
kleinere Abmessungen besitzen als die durch das
Paßloch-System definierte Fläche.

5. Verfahren nach einem der vorhergehenden Ansprüche, dadurch gekennzeichnet, daß während des
Aushärtevorgangs in einer mechanischen Presse
kein Druck auf die Verbindungselemente ausgeübt
wird.

6. Verfahren nach Anspruch 5, dadurch gekennzeichnet, daß die Laminate mittels den Verbindungselementen unter Verformung derart verspannt werden,
daß deren Endflächen gegenüber den Außenflächen
des fixierten Lagenaufbaus so weit zurückgesetzt
sind, daß die Presse keinen Druck auf die Verbindungselemente ausübt.

7. Verfahren nach Anspruch 5, dadurch gekennzeichnet, daß die Verbindungselemente so angeordnet
sind, daß sie außerhalb der Preßplatten, zu
liegen kommen.

8. Verfahren nach einem der vorhergehenden Ansprüche
1 bis 4, dadurch gekennzeichnet, daß der Aushärtevorgang unter Vakuum oder hydraulischem oder
pneumatischem Druck stattfindet.

9. Verfahren nach einem der vorhergehenden Ansprüche, dadurch gekennzeichnet, daß mit den mechanischen Verbindungselementen sowohl die Lageausrichtung der Laminate als auch deren relative Fixierung zueinander bewirkt werden.

10. Verfahren nach Anspruch 9, dadurch gekennzeichnet, daß die Verbindungselemente unter entsprechender Passung mindestens durch zwei Paßlöcher hindurchgeführt werden.

11. Verfahren nach Anspruch 10, dadurch gekennzeichnet, daß als Verbindungselemente Nieten benutzt werden.

12. Verfahren nach Anspruch 11, dadurch gekennzeichnet, daß als Nieten Hohlnieten oder Blechnieten eingesetzt werden.

13. Verfahren nach Anspruch 10, dadurch gekennzeichnet, daß als Verbindungselemente Schraubverbindungen benutzt werden.

14. Verfahren nach einem der vorhergehenden Ansprüche 1 bis 8, dadurch gekennzeichnet, daß die Lageausrichtung der Laminate mittels einer Paßstiftanordnung eines Hilfswerkzeugs erfolgt und die mechanischen Verbindungselemente nach Ausrichtung angebracht werden.

15. Verfahren nach Anspruch 14, dadurch gekennzeichnet, daß als Verbindungselemente Klammerverbindungen eingesetzt werden.

16. Verfahren nach Anspruch 14, dadurch gekennzeichnet, daß die Verbindung der Laminate durch Verschweißen hergestellt wird.

17. Verfahren nach einem oder mehreren der vorhergehenden Ansprüche, dadurch gekennzeichnet, daß der vorfixierte Lagenaufbau nach dem Mass-Laminationsverfahren um ein oder zwei Leiterebenen erweitert und in dieser Verbindung einem einzigen Aushärtevorgang unterworfen wird.

18. Lagenaufbau zur Herstellung von Mehrlagenleiterplatten mit in wenigstens drei Ebenen liegenden Leiterbildern, bei dem

wenigstens zwei Laminate (1, 2) unter Zwischenschaltung wenigstens eines Prepregs (3) übereinander angeordnet und

mittels eines Paßloch-Systems (4), mit dem die Laminate (1, 2) im Randbereich versehen sind, relativ zueinander ausgerichtet sind,

dadurch gekennzeichnet, daß

der Lagenaufbau unter Verwendung von mechanischen Verbindungselementen (5) so zusammengefügt ist, daß die Laminate (1, 2) relativ zueinander fixiert sind.

19. Lagenaufbau nach Anspruch 18, dadurch gekennzeichnet, daß er nach einem Verfahren nach einem
der vorhergehenden Ansprüche 2 bis 17 hergestellt
ist.

20. Verwendung des vorfixierten Lagenaufbaus gemäß
einem der Ansprüche 18 und 19 zur Herstellung von
Mehrlagenleiterplatten.

## FIG.1

## FIG.2

FIG.3

FIG.4